# EUROPEAN PATENT APPLICATION

(11) **EP 4 727 286 A1**
(43) Date of publication of application: **15.04.2026**
(21) Application number: 25207184.0
(22) Date of filing: 07.10.2025
(51) Int. Cl.: H10D 30/47, H10D 30/01, H10D 62/17, H10D 64/00, H10D 64/23, H10D 64/27, H10D 62/85

(54) **MANUFACTURING METHOD FOR HIGH ELECTRON MOBILITY TRANSISTOR**

(30) Priority: 11.10.2024 US 202463706140 P
(71) Applicant: Ultraband Technologies Inc., Zhubei City Hsinchu County 302058 (TW)
(72) Inventor: WU, Chan-Shin, Zhubei City, Hsinchu County (TW)
(74) Representative: Rapisardi, Mariacristina

(57) **Abstract**

The present disclosure provides a manufacturing method for a high electron mobility transistor, and the method includes the following steps: providing a semiconductor substrate (100); forming a protection layer (200A) at a position that is above the semiconductor substrate (100) and that corresponds to a gate opening (202); forming a cover layer (112) above the semiconductor substrate (100) and around the protection layer (200A), and removing the protection layer (200A) to form the gate opening (202); and forming a p-type layer (P) above the gate opening (202) and the cover layer (112), where a material of the cover layer (112) is undoped, un-intentionally doped, or n-type-doped gallium nitride or aluminum gallium nitride. Compared with the previous technology, the manufacturing method simplifies an overall process, further reduces a technical threshold, and can separately control and obtain good threshold voltage (Vth) and good conductive impedance (Rds (ON)), so that a product yield can be effectively improved.

## Description

### BACKGROUND OF THE INVENTION

### 1. Field of the Invention

The present disclosure provides a manufacturing method for a transistor, and specifically, provides a manufacturing method for a high electron mobility transistor. However, the present disclosure is not limited thereto.

### 2. Description of the Related Art

In the semiconductor industry, a high-voltage switch transistor such as a high electron mobility transistor (HEMT), a junction filed effect transistor (JFET), or a power metal-oxide-semiconductor field-effect transistor (power MOSFET) is often used as a semiconductor switch component of a high-voltage high-power device. Because of advantages such as a high-power density, a high-breakdown voltage, a high-output voltage, and a high switch frequency, the high electron mobility transistor causes extremely little damage to a device in a high-voltage operating environment, and gradually becomes a widely used transistor.

Specifically, excellent attributes of the high electron mobility transistor mostly depend on material features of GaN, such as a wide bandgap, a high critical electric field, and a high carrier mobility. In addition, a unique polarization effect of the GaN enables an AlGaN/GaN heterogeneous structure to sense and form two dimensional electron gases (2DEGs) in an interface block when the AlGaN/GaN heterogeneous structure is not doped, so that AlGaN/GaN HEMTs can output a high current to work and have a very low on-resistance.

In practice, the high electron mobility transistor may be set to an enhanced-mode semiconductor device (E-mode), that is, set to a normally off (normally OFF) structure, and have a positive-value threshold voltage. Therefore, a p-type layer is usually disposed at a position below a corresponding gate electrode in the high electron mobility transistor, and the p-type layer includes a p-type-doped material. In this way, when the device is not biased, the two dimensional electron gases are depleted, thereby achieving an effect of normally off. Currently, in a manufacturing method for the foregoing structure, the p-type layer is usually further formed only after a metal of a source and a metal of a drain are formed. Therefore, to form the p-type layer through patterning, a special etching process needs to be used to remove a part of the p-type layer, and it is noted that an underlying layer cannot be excessively etched in the process, nor can a metal of the electrode be polluted, to avoid a situation of subsequent leakage or failure of the device. The special etching process is, for example, an atomic layer etching (ALE) process, which is a technology in which a thin layer of a material is removed by using sequential self-limiting reactions.

### BRIEF SUMMARY OF THE INVENTION

An atomic layer etching process mentioned in the conventional technology costs a lot, has a high technical threshold, and is very time-consuming. To ensure that a product has a sufficient threshold voltage (Vth), a thickness of a barrier layer of a transistor usually cannot be excessively thick. However, the inventor finds that manufacturing of the transistor by using the foregoing method may cause surface damage of the barrier layer due to excessive etching, and further cause a negative impact on a yield. In addition, there may be a problem that a charge quantity is reduced and a conductive impedance (Rds (ON)) is increased due to deepening of a deficient region at a spacing between a source and a drain. According to this, the inventor provides a technology: First, a protection layer is formed on at a position on a barrier layer of a semiconductor substrate corresponding to a preformed gate. Next, based on a material difference between the protection layer and a cover layer and a material feature of the protection layer, a cover layer that is undoped, un-intentional doped, or n-type-doped is selectively formed around the protection layer, and the protection layer is removed to form a gate opening. Then, a p-type layer is formed above the gate opening and the cover layer. In this way, in addition to that the protection layer can be removed by using a simple etching method to form the gate opening, an overall process is simplified because the p-type layer does not need to be patterned. In addition, because a specific cover layer is disposed below the p-type layer, a negative impact of the p-type layer on a conductive impedance can be relieved when the threshold voltage is increased. Based on this, the present disclosure may separately control the foregoing factors related to the threshold voltage and the conductive impedance. More specifically, the present disclosure not only can avoid problems of a decrease in a yield and an increase in the conductive impedance, but also has a higher tolerance to a thickness of the barrier layer, to ensure that a finished product has a sufficient threshold voltage.

In view of this, an aspect of the present disclosure provides a manufacturing method for a high electron mobility transistor, and the method includes the following steps: (a) providing a semiconductor substrate, where the semiconductor substrate includes a channel layer and a barrier layer located above the channel layer; (b) forming a protection layer at a position that is above the semiconductor substrate and that corresponds to a gate opening; (c) forming a cover layer above the semiconductor substrate and around the protection layer, and removing the protection layer to form the gate opening; and (d) forming a p-type layer above the gate opening and the cover layer, where a material of the cover layer is undoped, un-intentionally doped, or n-type-doped gallium nitride or aluminum gallium nitride.

According to an embodiment of the present disclosure, the manufacturing method further includes the following steps: (e) forming a first dielectric layer above the p-type layer through patterning, to expose the p-type layer at positions corresponding to a source opening and a drain opening, and defining an active region; (f) performing an etching process at the positions corresponding to the source opening and the drain opening, to form the source opening and the drain opening; (g) forming an ohmic contact metal layer above the source opening and the drain opening through patterning, and alloying the ohmic contact metal layer; (h) forming a second dielectric layer through patterning, to cause the second dielectric layer to cover a part of the first dielectric layer; (i) forming a first metal layer through patterning, to cause the first metal layer to cover the positions corresponding to the source opening, the gate opening, and the drain opening, and cover a part of the first dielectric layer and a part of the second dielectric layer; and (j) forming a second metal layer through patterning, to cause the second metal layer to cover the positions corresponding to the source opening and the drain opening, and cover a part of the first metal layer.

According to an embodiment of the present disclosure, a length of the gate opening is in a range of 1.0 micrometer to 3.0 micrometers.

According to an embodiment of the present disclosure, a material of the protection layer is silicon nitride.

According to an embodiment of the present disclosure, a thickness of the protection layer is in a range of 20 nanometers to 50 nanometers.

According to an embodiment of the present disclosure, the protection layer is formed by using a low pressure chemical vapor deposition (LPCVD) method.

According to an embodiment of the present disclosure, a thickness of the cover layer is in a range of 50 nanometers to 150 nanometers.

According to an embodiment of the present disclosure, a material of the p-type layer is p-type-doped gallium nitride.

According to an embodiment of the present disclosure, a thickness of the p-type layer is in a range of 70 nanometers to 100 nanometers.

According to an embodiment of the present disclosure, before forming the protection layer, the method further includes the following step: forming an in situ dielectric layer above the barrier layer.

According to an embodiment of the present disclosure, a thickness of the in situ dielectric layer is in a range of 2.0 nanometers to 3.0 nanometers.

According to an embodiment of the present disclosure, a material of the first dielectric layer is silicon nitride.

According to an embodiment of the present disclosure, the first dielectric layer is formed by using a low pressure chemical vapor deposition method.

According to an embodiment of the present disclosure, the first dielectric layer covers a part of the p-type layer.

According to an embodiment of the present disclosure, the source opening and the drain opening are respectively a groove exposing the barrier layer or a groove exposing the channel layer.

According to an embodiment of the present disclosure, a process temperature of alloying the ohmic contact metal layer is in a range of 500 °C to 550 °C.

According to an embodiment of the present disclosure, a material of the second dielectric layer is silicon nitride.

According to an embodiment of the present disclosure, the second dielectric layer is formed by using a plasma-enhanced chemical vapor deposition (PECVD) method.

According to an embodiment of the present disclosure, a thickness of the second dielectric layer is less than or equal to 500 nanometers.

In conclusion, in the manufacturing method for a high electron mobility transistor provided in the present disclosure, because differences in lattice matching features and many advantages of the protection layer, the barrier layer, and the cover layer are suitably used, in addition to that the protection layer can be removed by using a simple etching method to form the gate opening, an overall process is simplified because the p-type layer does not need to be patterned. In this way, not only problems of a decrease in a yield and an increase in the conductive impedance can be avoided, but also a higher tolerance is provided to the thickness of the barrier layer, to ensure that a finished product has a sufficient threshold voltage. In addition, because a specific cover layer is disposed below the p-type layer, a negative impact caused when the p-type layer improves the threshold voltage on the conductive impedance can be relieved.

### BRIEF DESCRIPTION OF THE DRAWINGS

To make the foregoing and other objectives, features, advantages, and embodiments of the present disclosure more comprehensible, the accompanying drawings are described as follows.
FIG. 1 and FIG. 2 are flowcharts of steps of a manufacturing method for a high electron mobility transistor according to an embodiment of the present disclosure; and
FIG. 3 to FIG. 14 are respectively schematic cross-sectional views of a high electron mobility transistor structure at different manufacturing stages according to an embodiment of the present disclosure.

According to a common operation manner, various features and components in the figure are not drawn to scale, and a drawing manner is to present specific features and components related to the present disclosure in an optimal manner. In addition, in different drawings, similar components and parts are referred to by using same or similar component symbols.

### DETAILED DESCRIPTION OF THE INVENTION

To make the descriptions of the present disclosure more detailed and complete, the following provides illustrative descriptions for implementations and specific embodiments of the present disclosure, but the descriptions are not the only forms of implementing or using the specific embodiments of the present disclosure. In the scope of this specification and the appended claims, unless the context indicates otherwise, "a" and "the" may also be interpreted as a plurality. In addition, in this specification and the patent scope of the appended claims, unless otherwise specified, "disposed on an object" may be considered as directly or indirectly attached or in contact with a surface of the object. The definition of the surface should be determined based on semantic meanings before/after the content of the specification and general knowledge of the field to which the present disclosure belongs.

Although numerical ranges and parameters used to define the present disclosure are approximate values, relevant values in the specific embodiments are presented as precisely as possible herein. However, any value essentially inevitably includes a standard deviation caused by an individual test method. The term "about" usually refers to that an actual value is within plus or minus 10%, 5%, 1%, or 0.5% of a specific value or range. Alternatively, the term "about" represents that an actual value falls within an acceptable standard error of an average value, and is determined by consideration of a person of ordinary skill in the art to which the present disclosure belongs. Therefore, unless otherwise specified to the contrary, numerical parameters disclosed in this specification and accompanying patent scope are approximate values, and may be modified according to requirements. These numerical parameters should be understood as at least a specified quantity of valid digits and a numerical value obtained by using a common carrying method.

### Terms

As used in this specification, the term "high electron mobility transistor" may be a natural normally on structure, and has a negative threshold voltage. The high electron mobility transistor may also switch to a normally off structure, and has a positive threshold voltage. In addition, the "semiconductor material" in the present disclosure may include a chemical compound of a plurality of elements. The element includes, but is not limited to, one or more elements belonging to different classes in the periodic table, such as GaN. These chemical compounds may include pairs of elements from Group 13 (which includes boron (B), aluminum (Al), gallium (Ga), indium (In) and thallium (Tl)) and elements from Group 15 (which includes nitrogen (N), phosphorus (P), arsenic (As), antimony (Sb) and bismuth (Bi)); or pairs of elements from Group 14 (which includes carbon (C), silicon (Si), germanium (Ge) and tin (Sn)), such as silicon carbide (SiC) or silicon-germanium alloys. Group 13 to Group 15 of the periodic table may be respectively referred to as Group III, Group IV, and Group V.

As used in this specification, the term "exposure" refers to a structure in which a surface of an object is not completely covered, and a structure of one or more openings or slots may be formed on the surface of the object. However, specific defining content should be determined according to semantic meaning of a paragraph before/after the content of the specification and common knowledge in the field to which this specification belongs.

As used herein, the term "suitable epitaxial grown or deposition process" includes, but is not limited to, a chemical vapor deposition (CVD) method, a low pressure chemical vapor deposition (LPCVD) method, an atmospheric pressure chemical vapor deposition (APCVD) method, an ultrahigh vacuum chemical vapor deposition (UHVCVD) method, an atomic layer deposition (ALD) method, a molecular layer deposition (MLD) method, a plasma enhanced chemical vapor deposition (PECVD) method, a metal-organic chemical vapor deposition (MOCVD) method, molecular beam epitaxy (MBE), sputtering, or the like, or a combination thereof.

As used in this specification, the term "photoresist" refers to a light-sensitive material commonly applied to a processing process of an integrated circuit and a semiconductor component. After being exposed to illumination or radiation such as ultraviolet light, deep ultraviolet light, an electron beam, an ion beam, or X-ray, a difference occurs in solubility, so that the surface of the object can be patterned according to an objective of a user. The photoresist may be divided into a positive photoresist and a negative photoresist. After exposure and development of the positive photoresist, a pattern the same as a pattern of a reticle is obtained. Conversely, for the negative photoresist, an inverted pattern is obtained.

As used in this specification, the term "mask/reticle" refers to a light masking device commonly applied to a processing process of an integrated circuit and a semiconductor component, and may be used to define a pattern on the surface of the object in the process, and perform patterning with the photoresist.

As used in this specification, the term "lift-off process" refers to a process in which the negative photoresist is used to form metal in a metal region, and then a sacrificial layer is dissolved through etching to remove metal attachments from other regions that the metal does not need to be generated.

As used in this specification, the term "suitable etching process" includes, but is not limited to, dry etching and wet etching. The dry etching includes physical bombardment methods such as reactive ion etching (RIE) and inductively coupled plasma (ICP) etching, and the wet etching is a chemical solution etching method well known in the art of the present disclosure.

In the following descriptions of the present disclosure, a person of ordinary skill in the technical field can easily understand the necessary technical content of the present disclosure, and change and modify the present disclosure to adapt to different uses and conditions without violating the spirit and scope thereof. Other implementations also fall within the patent scope of the present disclosure.

### Embodiments

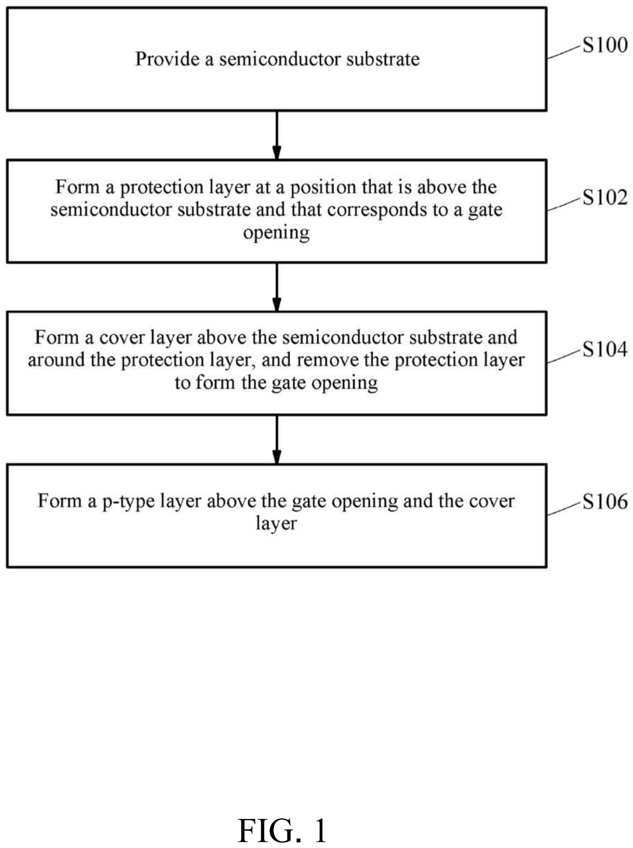

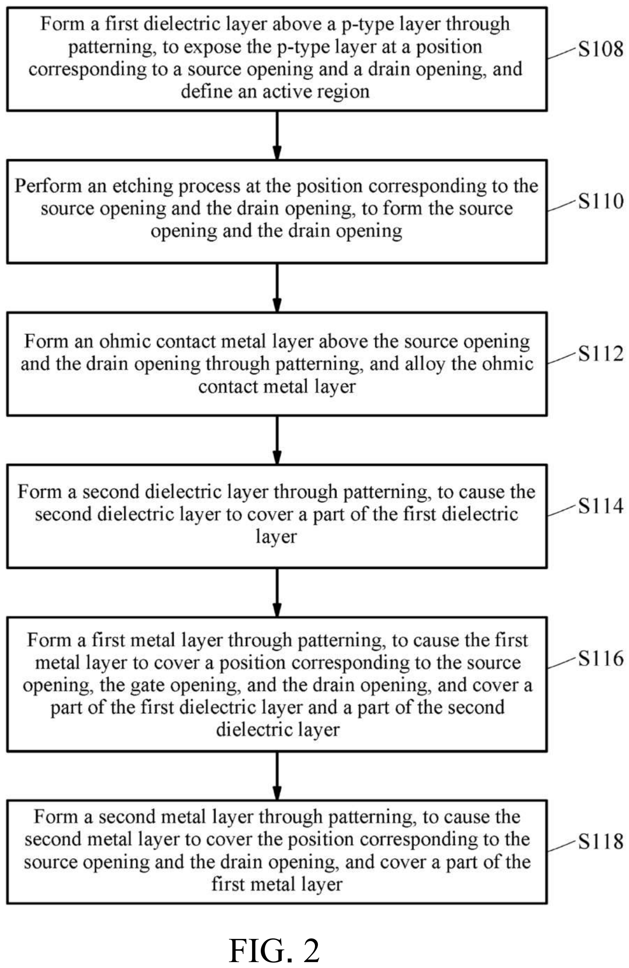

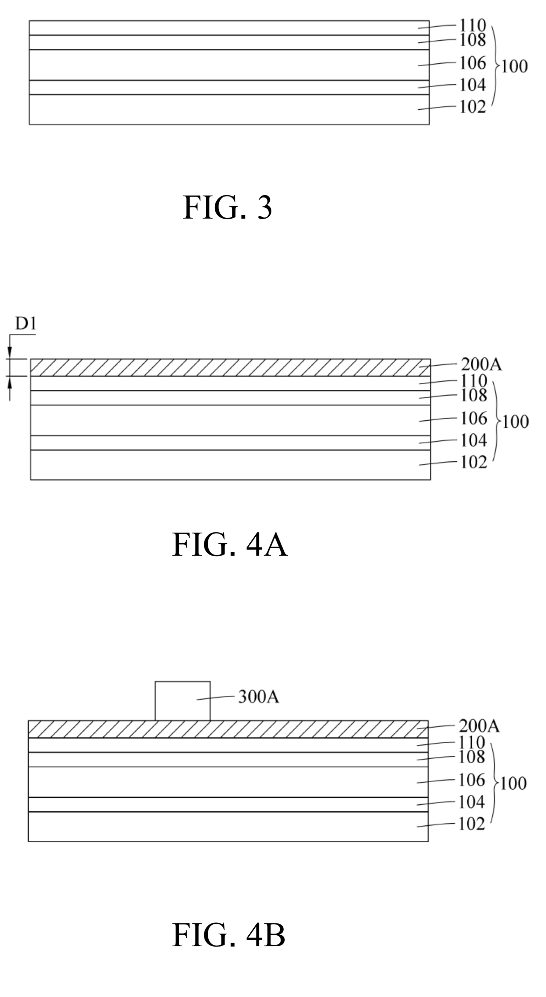

FIG. 1 and FIG. 2 are flowcharts of steps of a manufacturing method for a high electron mobility transistor according to an embodiment of the present disclosure; and FIG. 3 to FIG. 14 are respectively schematic cross-sectional views of a high electron mobility transistor structure at different manufacturing stages according to an embodiment of the present disclosure.

First, refer to FIG. 1. The present disclosure provides a manufacturing method for a high electron mobility transistor, and the method generally includes the following steps. Step S100: Provide a semiconductor substrate. Step S102: Form a protection layer at a position that is above the semiconductor substrate and that corresponds to a gate opening. Step 104: Form a cover layer above the semiconductor substrate and around the protection layer, and remove the protection layer to form the gate opening. Step 106: Form a p-type layer above the gate opening and the cover layer.

Referring to FIG. 2, the manufacturing method for a high electron mobility transistor of the present disclosure further includes the following steps. Step S108: Form a first dielectric layer above the p-type layer through patterning, to expose the p-type layer at a position corresponding to the source opening and the drain opening, and define an active region. Step S110: Perform an etching process at the position corresponding to the source opening and the drain opening, to form the source opening and the drain opening. Step S112: Form an ohmic contact metal layer above the source opening and the drain opening through patterning, and alloy the ohmic contact metal layer. Step S114: Form a second dielectric layer through patterning, to cause the second dielectric layer to cover a part of the first dielectric layer. Step S116: Form a first metal layer through patterning, to cause the first metal layer to cover a position corresponding to the source opening, the gate opening, and the drain opening, and cover a part of the first dielectric layer and a part of the second dielectric layer. Step S118: Form a second metal layer through patterning, to cause the second metal layer to cover the position corresponding to the source opening and the drain opening, and cover a part of the first metal layer.

FIG. 3 shows a semiconductor substrate 100 provided in step S100. Refer to FIG. 1 and FIG. 3 together. According to some embodiments of the present disclosure, the semiconductor substrate 100 is a structure disposed based on an aluminum gallium nitride (AlGaN)/gallium nitride (GaN) high electron mobility transistor, and is an epitaxial grown layer. Specifically, the semiconductor substrate 100 includes a channel layer 108 and a barrier layer 110 disposed above the channel layer 108. In addition, there is a heterogeneous material interface between the channel layer 108 and the barrier layer 110, so that a two dimensional electronic gas region may be formed near the interface in the channel layer 108. However, the two dimensional electronic gas region thereof may form a conduction channel for a free electron when the region is biased, thereby achieving an objective such as electrically coupling a source electrode and a drain electrode. Further, a material of the channel layer 108 is undoped or un-intentional doped GaN, and a thickness of the channel layer 108 is in a range of 50 nm to 1000 nm, for example, 50 nm, 100 nm, 150 nm, 200 nm, 250 nm, 300 nm, 350 nm, 400 nm, 450 nm, 500 nm, 550 nm, 600 nm, 650 nm, 700 nm, 750 nm, 800 nm, 850 nm, 900 nm, 950 nm, or 1000 nm, or is in a range between any two of the foregoing values, and preferably, is in a range of 150 nm to 1000 nm. A material of the barrier layer 110 is undoped or un-intentional doped AlₓGa₁₋ₓN, where x is approximately in a range of 0.1 to 1, for example, 0.1, 0.2, 0.3, 0.4, 0.5, 0.6, 0.7, 0.8, or 0.9, or in a range between any two of the foregoing values. A thickness of the barrier layer 110 is in a range of 10 nm to 40 nm, for example, 10 nm, 15 nm, 20 nm, 25 nm, 30 nm, 35 nm, or 40 nm, or is in a range between any two of the foregoing values, and preferably, is in a range of 10 nm to 20 nm.

According to a preferred embodiment of the present disclosure, layer structures of the semiconductor substrate 100 are respectively, from bottom to top, a base 102, a nuclear layer 104, a buffer layer 106, a channel layer 108, and a barrier layer 110. According to a more preferred embodiment, a top of the barrier layer 110 may further include a cap layer (not shown in the figure), and a thickness of the cap layer is in a range of 1.5 nm to 2.0 nm, for example, 1.5 nm, 1.6 nm, 1.7 nm, 1.8 nm, 1.9 nm, or 2.0 nm, or is in a range between any two of the foregoing values. The base 102 includes a wafer, which may be, for example, a semi-isolating substrate or an un-intentional doped substrate, for example, a wafer made of a high-quality single-crystal silicon semiconductor material, for example, any polymorph of sapphire, GaN, GaAs, silicon crystal, silicon carbide (SiC) (including wurtzite), AlN, InP, or a similar substrate material used for the semiconductor. The nuclear layer 104 may include an undoped or un-intentional doped AIN compound. The buffer layer 106 is configured to compensate for a mismatching situation between layers, and includes undoped, un-intentional doped, or carbon-mixed GaN.

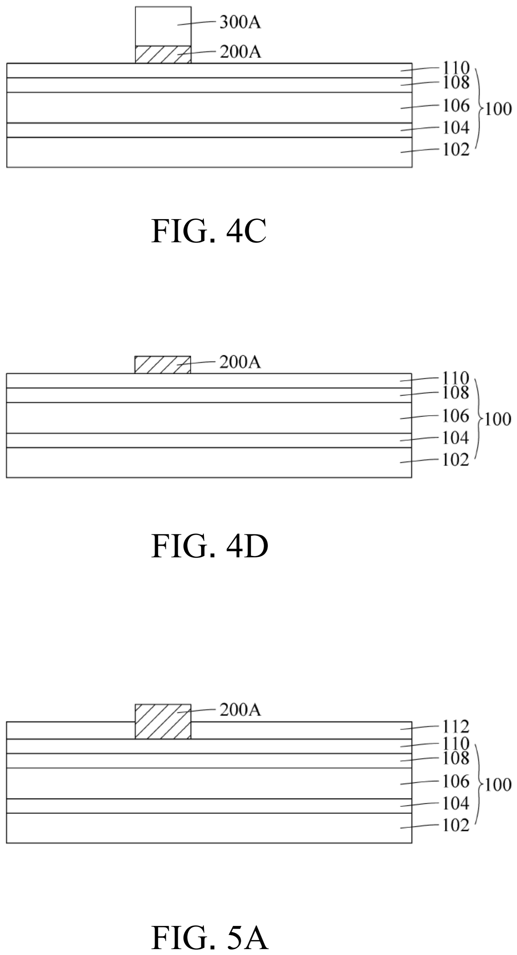

FIG. 4A to FIG. 4D show structural change situations of forming a protection layer 200A at a position that is above the semiconductor substrate 100 and that corresponds to the gate opening in step S102. Refer to FIG. 1, FIG. 4A to FIG. 4D together. First, a material of the protection layer 200A is disposed above the semiconductor substrate 100 by using a suitable epitaxial grown or deposition process. The protection layer 200A needs to be capable of bearing a high-temperature epitaxial process. In addition, the protection layer 200A needs to be different from the barrier layer 110 in a lattice matching feature, so that the barrier layer 110 can be selectively manufactured. Moreover, the protection layer 200A needs to avoid generating excessive stress, and also needs to avoid reaction with the barrier layer 110. Preferably, a process of disposing the protection layer 200A uses a low pressure chemical vapor deposition method, and a process temperature of the protection layer 200A is greater than 800 °C, for example, 850 °C, 900 °C, 950 °C, 1000 °C, 1050 °C, or 1100 °C, or is in a range between any two of the foregoing values. In addition, the material of the protection layer 200A is at least one of silicon oxide (SiO₂), silicon oxynitride (SiONₓ), or silicon nitride (SiNₓ) (where x is approximately in a range of 0.1 to 1.0), and is preferably silicon nitride. A thickness D1 of the protection layer 200A is in a range of 20 nm to 75 nm, for example, 20 nm, 25 nm, 30 nm, 35 nm, 40 nm, 45 nm, 50 nm, 55 nm, 60 nm, 65 nm, 70 nm, or 75 nm, or in a range between any two of the foregoing values, and preferably, is in a range of 20 nm to 50 nm.

Further, a suitable etching process is performed in cooperation with a mask 300A to pattern the protection layer 200A, so that the protection layer 200A is specifically disposed at a position on the semiconductor substrate 100 at which a gate electrode is preformed, to protect a subsequent gate opening. The remaining protection layer 200A is removed. Subsequently, the mask 300A is removed. Specifically, a distance between the protection layer 200A corresponding to each gate opening after patterning needs to be greater than or equal to 7 micrometers, for example, 7 micrometers, 8 micrometers, 9 micrometers, or 10 micrometers, to avoid a pile up at an edge when a material is formed in a region not having the protection layer 200A. Preferably, the distance is equal to a gate width (Wg) of a subsequently manufactured component.

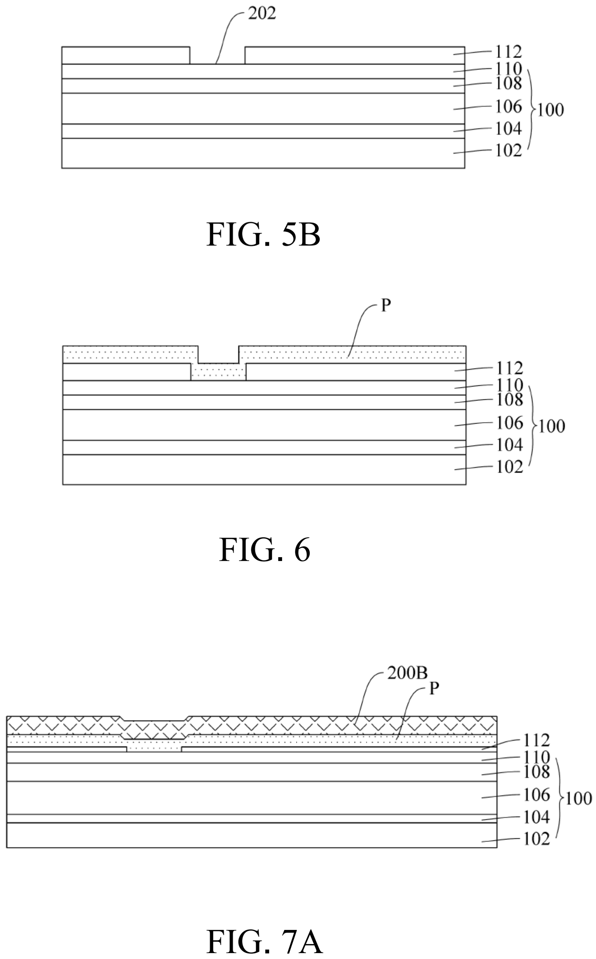

FIG. 5A and FIG. 5B show structural change situations of forming a cover layer 112 above the semiconductor substrate 100 and around the protection layer 200A and removing the protection layer 200A in step S104. Refer to FIG. 1, FIG. 5A, and FIG. 5B together. A material of the cover layer 112 is disposed above the semiconductor substrate 100 by using a suitable epitaxial grown or deposition process. Preferably, a metal organic chemical vapor deposition (MOCVD) method is used. The cover layer 112 may be used to provide a large transduction upper limit, a saturation current, a current gain cut-off frequency, and a maximum vibration frequency, and may reduce a drain-to-source conductive impedance (Rds (ON)). The material of the cover layer 112 is undoped, un-intentional doped, or n-type-doped gallium nitride or aluminum gallium nitride. Preferably, the material of the cover layer 112 is undoped or un-intentional doped aluminum gallium nitride (AlₓGa₁₋ₓN, where x is approximately in a range of 0.1 to 1, and is preferably greater than an AI mole fraction of the material of the barrier layer 110).

Based on a lattice matching property of the material of the cover layer 112, the cover layer 112 is selectively deposited on a surface not covered by the protection layer 200A. In other words, the cover layer 112 is selectively formed around the protection layer 200A. Without being limited to a specific theory, the cover layer 112 can further serve as an extension of the barrier layer 110, thereby improving a charge density of the channel layer 108. Preferably, in this way, a charge quantity included in the transistor may be separately regulated, to obtain an ideal breakdown voltage. In this way, the present disclosure preferably can further thin the barrier layer 110, so that a subsequently manufactured transistor has a higher threshold voltage (Vth). Specifically, the thickness of the barrier layer may be in a range of 12 nm to 25 nm, for example, 12 nm, 13 nm, 14 nm, 15 nm, 16 nm, 17 nm, 18 nm, 19 nm, 20 nm, 21 nm, 22 nm, 23 nm, 24 nm, or 25 nm, or may be in a range between any two of the foregoing values. Further, the protection layer 200A is selectively removed to expose a position on the semiconductor substrate 100 at which the gate electrode is preformed, and form a gate opening 202. Specifically, based on a structural and compositional difference between the protection layer 200A and the cover layer 112, the protection layer 200A can be selectively removed by using a suitable etching process herein. In this way, the gate opening 202 can be formed in a simpler manner compared with the previous technology. According to some embodiments of the present disclosure, a length of the gate opening 202 is in a range of 1.0 micrometer to 3.0 micrometers, for example, 1.0 micrometer, 1.2 micrometers, 1.4 micrometers, 1.6 micrometers, 1.8 micrometers, 2.0 micrometers, 2.2 micrometers, 2.4 micrometers, 2.6 micrometers, 2.8 micrometers, or 3.0 micrometers, or is in a range between any two of the foregoing values.

FIG. 6 shows a structural change situation of forming a p-type layer P above the gate opening 202 and the cover layer 112 in step S106. Refer to FIG. 1 and FIG. 6 together. A material of the p-type layer P is disposed above the semiconductor substrate 100 by using a suitable epitaxial grown or deposition process. Preferably, the process is performed by using the metal organic chemical vapor deposition method, and a process temperature thereof is in a range of 800 °C to 1200 °C, for example, 850 °C, 900 °C, 950 °C, 1000 °C, 1050 °C, 1100 °C, 1150 °C, or 1200 °C, or is in a range between any two of the foregoing values.

For the material, the p-type layer P may include p-type gallium nitride (p-GaN), p-type aluminum gallium nitride (p-AlGaN), or p-type silicon carbide (p-SiC). Preferably, the p-type layer P includes p-type gallium nitride (p-GaN), and preferably includes a p-type dopant, for example, Mg, and a dope concentration of the p-type dopant is in a range of 3×10¹⁷ cm⁻³ to 3×10¹⁹ cm⁻³. Because of a lattice matching property of the p-type layer P, when the p-type layer P is formed, the p-type layer P is entirely deposited above the gate opening 202 and the cover layer 112. According to some embodiments of the present disclosure, a thickness of the p-type layer P is in a range of 70 nm to 100 nm, for example, 70 nm, 75 nm, 80 nm, 85 nm, 90 nm, 95 nm, or 100 nm, or is in a range between any two of the foregoing values, and preferably, is in a range of 70 nm to 85 nm. Without being limited to a specific theory, if the thickness of the p-type layer P is excessively thin, a forward bias that the device can bear may be insufficient. Consequently, an application of the device is limited. However, if the thickness is excessively thick, an excessively large spacing between the gate and the channel layer 108 may be caused, so that a value of the threshold voltage excessively changes to a negative direction. According to some other embodiments of the present disclosure, the material of the p-type layer P is p-type gallium nitride, and an area dope concentration of the p-type layer P is in a range of 2×10^{12.}cm⁻² to 5×10^{12.}cm⁻², for example, 2.0×10¹² cm⁻², 2.5×10¹² cm⁻², 3.0×10¹² cm⁻², 3.5×10¹² cm⁻², 4.0×10^{12.}cm⁻², 4.5×10^{12.}cm⁻², or 5.0×10^{12.}cm⁻², or is in a range between any two of the foregoing values.

Referring to FIG. 5A to FIG. 6, based on the present disclosure, the cover layer 112 is disposed first, and then the p-type layer P is disposed. Therefore, for the structure, the cover layer 112 is disposed between the p-type layer P and the barrier layer 110. In this way, without being limited to a specific theory, disposition of the cover layer 112 can relieve a negative impact generated by the p-type layer P on a conductive impedance of a region except the gate in the channel layer 108 below. Based on this, according to some embodiments of the present disclosure, the thickness of the cover layer 112 is in a range of 50 nm to 150 nm, for example, 50 nm, 60 nm, 70 nm, 80 nm, 90 nm, 100 nm, 110 nm, 120 nm, 130 nm, 140 nm, or 150 nm, or is in a range between any two of the foregoing values. Preferably, the thickness of the cover layer 112 is in a range of 100 nm to 150 nm, so that it is beneficial to increasing a charge quantity in the channel layer 108, increasing a distance between the p-type layer P and the channel layer 108, and further relieving an impact caused by the p-type layer P.

According to some embodiments of the present disclosure, a material layer (not shown in the figure) may be further disposed below the p-type layer P at the gate opening 202. The material layer is configured to improve a forward bias that the entire device can bear and maintain the threshold voltage within a suitable range. Without being limited to a specific theory, the material layer needs to have features of both a high breakdown electric field and a high dielectric coefficient. If the material layer has only the high breakdown electric field but does not have the high dielectric coefficient, the material layer can increase a positive bias that the entire device can bear, and the threshold voltage excessively deviates toward a negative direction. However, if the device only has the high dielectric coefficient and does not have the high breakdown electric field, the device may not effectively improve a forward bias that the device can bear. Specifically, the material layer preferably includes SiO₂ or SiN, and more preferably, includes SiO₂. A thickness of the material layer is preferably in a range of 8 nm to 20 nm, for example, 8 nm, 10 nm, 12 nm, 14 nm, 16 nm, 18 nm, or 20 nm, or is in a range between any two of the foregoing values. More preferably, the material layer includes SiO₂ or SiN formed by using the low pressure chemical vapor deposition method, and more preferably, includes SiO₂ formed by using the low pressure chemical vapor deposition method. Without being limited to a specific theory, the material layer formed by using the low pressure chemical vapor deposition method can have a denser structure, and can further improve a critical breakdown field of the material.

According to some other embodiments of the present disclosure, a thickness of the protection layer 200A is greater than a thickness of the cover layer 112. Preferably, the thickness of the cover layer 112 is less than or equal to one-half of the thickness of the protection layer 200A.

In addition, refer to FIG. 4A to FIG. 6 together. According to some preferred embodiments of the present disclosure, before the protection layer 200A is formed, an in situ dielectric layer (not shown in the figure) of a same material may be formed above the semiconductor substrate 100, and a thickness of the in situ dielectric layer is in a range of 2.0 nm to 3.0 nm, for example, 2.0 nm, 2.1 nm, 2.2 nm, 2.3 nm, 2.4 nm, 2.5 nm, 2.6 nm, 2.7 nm, 2.8 nm, 2.9 nm, or 3.0 nm, or is in a range between any two of the foregoing values. Without being limited to a specific theory, the in situ dielectric layer not only can prevent the barrier layer 110 from being polluted without affecting the threshold voltage, but also can facilitate subsequent formation of the p-type layer. Specifically, if the in situ dielectric layer is not formed above the barrier layer 110 before the protection layer 200A is formed, when the cover layer 112 is formed above the barrier layer 110 and around the protection layer 200A by using an MOCVD process, because a process temperature of MOCVD is high (usually 1000 °C to 1100 °C), a reaction may occur at an interface between the protection layer 200A and the barrier layer 110 that is formed by LPCVD with a low process temperature (usually 800 °C to 850 °C), making it difficult to completely remove the protection layer 200A subsequently, so that it is difficult to subsequently form the p-type layer on the gate opening.

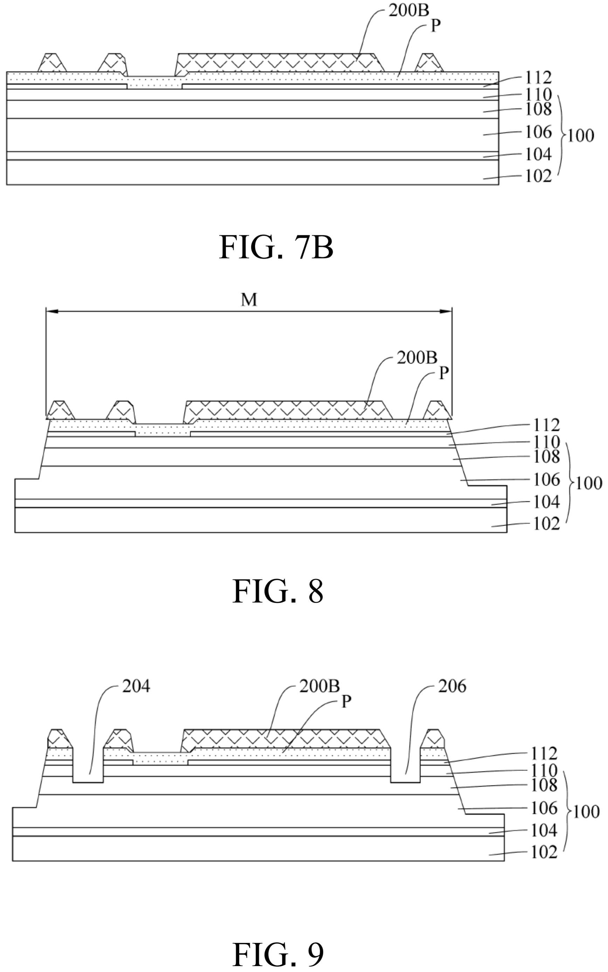

FIG. 7A, FIG. 7B, and FIG. 8 sequentially show a situation of forming a first dielectric layer 200B through patterning above a p-type layer P, and a structural change situation of defining an active region M in step S108. Refer to FIG. 2, FIG. 7A, FIG. 7B, and FIG. 8 together. First, a material of the first dielectric layer 200B is entirely deposited above the semiconductor substrate 100 by using a suitable epitaxial grown or deposition process. Preferably, the process is performed by using the low pressure chemical vapor deposition method, and a process temperature of the process is greater than 800 °C, for example, 850 °C, 900 °C, 950 °C, 1000 °C, 1050 °C, or 1100 °C. Further, the material of the first dielectric layer 200B is preferably at least one of silicon nitride (SiO₂), silicon oxynitride (SiONₓ), or silicon nitride (SiNₓ) (where x is approximately in a range of 0.1 to 1), and may be used as a field plate in the high electron mobility transistor, to regulate an electric field distribution and make the distribution more uniform, thereby further improving the breakdown voltage of the device and reducing a leakage current. In addition, the thickness of the first dielectric layer 200B is in a range of 150 nm to 300 nm, for example, 150 nm, 160 nm, 170 nm, 180 nm, 190 nm, 200 nm, 210 nm, 220 nm, 230 nm, 240 nm, 250 nm, 260 nm, 270 nm, 280 nm, 290 nm, or 300 nm, or is in a range between any two of the foregoing values.

Further, the first dielectric layer 200B is patterned by using a suitable etching process to define positions predetermined to be used as the source electrode and the drain electrode, so that the first dielectric layer 200B covers a part of the p-type layer P, and the active region M is further defined by using a suitable etching process, so that components can operate independently without affecting each other. According to some embodiments of the present disclosure, in addition to using a suitable etching process, the step of defining the active region M may also use a suitable ion implantation process to change a resistance of the layer, to define the active region M. Preferably, the step of defining the active region M may also use a combination of the foregoing two processes.

FIG. 9 shows a structural change situation of forming a source opening 204 and a drain opening 206 in step S110. Refer to FIG. 2 and FIG. 9 together. In this step, a suitable etching process is used to further etch down to the barrier layer 110 or the channel layer 108 at positions on the first dielectric layer 200B at which the source electrode and the drain electrode are preformed, to form the source opening 204 and the drain opening 206 (a form of etching down to the channel layer 108 is shown in the figure). Specifically, both the source opening 204 and the drain opening 206 are a groove.

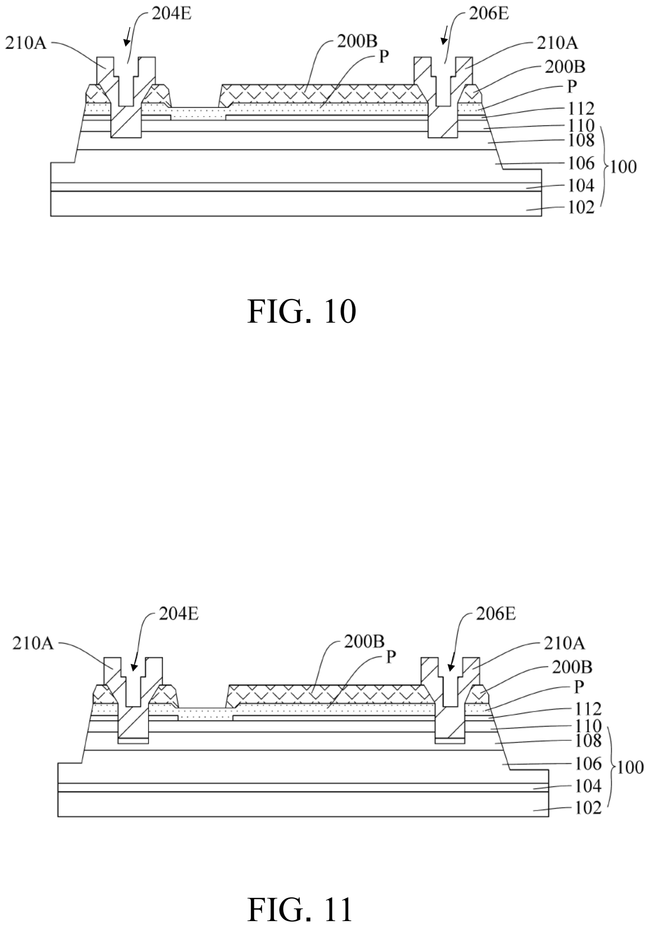

FIG. 10 and FIG. 11 show a structural change situation of forming an ohmic contact metal layer 210A above the source opening 204 and the drain opening 206 through patterning, and alloying the ohmic contact metal layer 210A in step S112. Refer to FIG. 2 and FIG. 9 to FIG. 11 together. The ohmic contact metal layer 210A is formed by matching a suitable mask and by using a suitable epitaxial grown or deposition process, and then the mask is removed, to restrictively form the ohmic contact metal layer 210A on the source opening 204 and the drain opening 206. Further, an alloying process is used to alloy the ohmic contact metal layer 210A formed on the source opening 204 and the drain opening 206 (as shown in FIG. 11), thereby forming a source electrode 204E and a drain electrode 206E respectively, and causing the high electron mobility transistor to generate an ohmic contact. According to some preferred embodiments of the present disclosure, because bottom surfaces of the source opening 204 and the drain opening 206 expose the channel layer 108, without being limited by a specific theory, the alloying process may be performed at a process temperature substantially lower than a process temperature in the conventional technology. Preferably, the process temperature is in a range of 500 °C to 550 °C, for example, 500 °C, 510 °C, 520 °C, 530 °C, 540 °C, or 550 °C, or is in a range between any two of the foregoing values. According to still some other preferred embodiments of the present disclosure, the manner of generating the ohmic contact may also be to form a high-doped n-type gallium nitride layer (not shown in the figure) on the bottom surfaces of the source opening 204 and the drain opening 206 respectively, where a carrier concentration of the layer is preferably greater than 10¹⁹ cm⁻³, and more preferably, molecular beam epitaxy (MBE) is used to set the carrier concentration of the layer to be greater than 10²⁰ cm⁻³. In this way, the alloying process is replaced and simplified. According to some embodiments of the present disclosure, the ohmic contact metal layer 210A may be made of any suitable conductive material capable of forming the ohmic contact or another conductive interface, and preferably, may be made of titanium (Ti), aluminum (Al), nickel (Ni), tantalum (Ta), molybdenum (Mo), gold (Au), or a combination thereof.

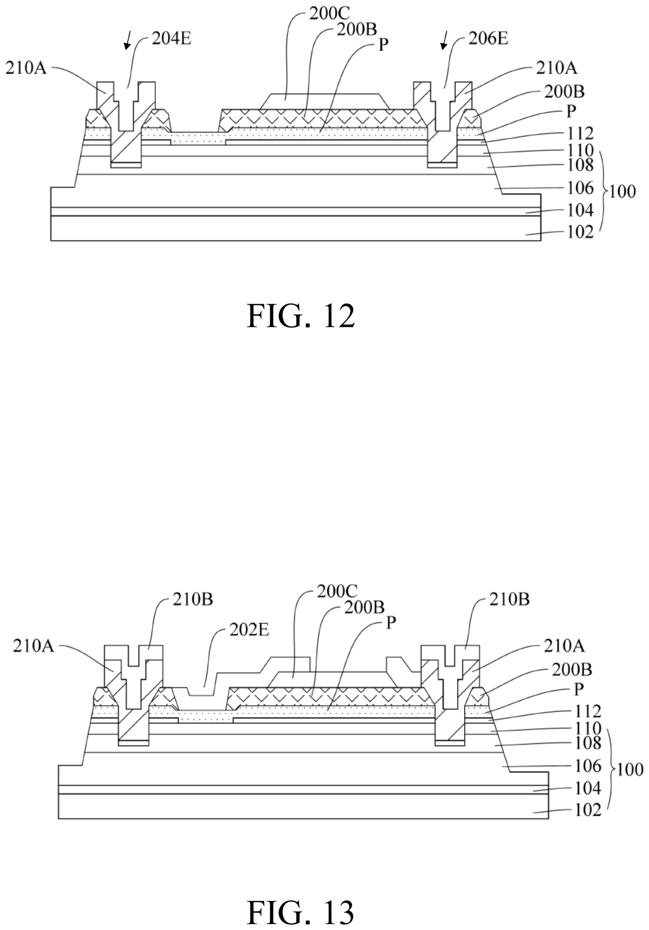

FIG. 12 shows a structural change situation of forming a second dielectric layer 200C through patterning in step S114. Refer to FIG. 2 and FIG. 12 together. After the source electrode 204E and the drain electrode 206E are formed, a material of the second dielectric layer 200C is entirely deposited above the semiconductor substrate 100 by using a suitable epitaxial grown or deposition process. Then, the second dielectric layer 200C is formed through patterning by using a suitable etching process, so that the second dielectric layer 200C covers a part of the first dielectric layer 200B. According to some embodiments of the present disclosure, the second dielectric layer 200C is formed by using a plasma-enhanced chemical vapor deposition (PECVD) method. According to some other embodiments of the present disclosure, the material of the second dielectric layer 200C may be the same as or different from the material of the first dielectric layer 200B, preferably at least one of silicon oxide SiO₂, silicon oxynitride SiONₓ, or silicon nitride SiNₓ (where x is approximately in a range of 0.1 to 1), and may be used as the field plate in the high electron mobility transistor. According to a more preferred embodiment of the present disclosure, materials of the first dielectric layer 200B and the second dielectric layer 200C are different. For example, the material of the first dielectric layer 200B is SiNₓ, while the material of the second dielectric layer 200C is SiO₂. In this way, when the second dielectric layer 200C is formed through patterning, a material difference between the first dielectric layer and the second dielectric layer may be used to achieve an effect of selective etching. In addition, a thickness of the second dielectric layer 200C is less than 500 nm, preferably is in a range of 200 nm to 300 nm, for example, 200 nm, 210 nm, 220 nm, 230 nm, 240 nm, 250 nm, 260 nm, 270 nm, 280 nm, 290 nm, or 300 nm, or is in a range between any two of the foregoing values. In addition, a region that covers a part of the first dielectric layer 200B and that is of the second dielectric layer 200C is substantially located between a position at which a gate is predetermined to be formed and the drain electrode 206E. However, a size of the specifically covered region is not limited in this specification.

FIG. 13 shows a structural change situation of forming the first metal layer 210B through patterning in step S116. Refer to FIG. 2 and FIG. 13 together. In this step, the first metal layer 210B is formed through patterning, so that the first metal layer 210B covers the p-type layer P, a part of the first dielectric layer 200B, a part of the second dielectric layer 200C, and the ohmic contact metal layer 210A. Specifically, the first metal layer 210B is formed by matching a suitable mask and by using a suitable epitaxial grown or deposition process, and then the mask is removed, to form the first metal layer 210B through patterning. Specifically, after the first metal layer 210B covers the p-type layer P, a gate electrode 202E is formed, and the first metal layer 210B covers regions such as a part of the first dielectric layer 200B, a part of the second dielectric layer 200C, and the ohmic contact metal layer 210A. However, a size of the specifically covered region is not limited in this specification. According to some embodiments of the present disclosure, the first metal layer 210B may be made of any conductive material capable of biasing or controlling the semiconductor device, preferably made of nickel (Ni), gold (Au), or a combination thereof, or made of zirconium (Zr), gold (Au), or a combination thereof.

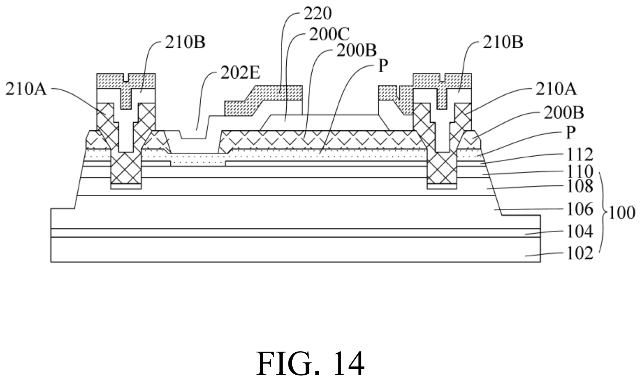

FIG. 14 shows a structural change situation of forming a second metal layer 220 through patterning in step S118. Refer to FIG. 2 and FIG. 14 together. After step S116 is performed, a second metal layer 220 and a cross-over layer (not shown in the figure) are further disposed through patterning. Both the second metal layer 220 and the cross-over layer are formed by using a suitable epitaxial grown or deposition process, and are patterned with a specific mask and/or a photoresist. It is assumed that the gate electrode 202E is restrictively disposed on a region except the gate electrode 202E. The second metal layer 220 is configured to electrically connect same electrodes between different components, and is made of any suitable conductive material. The cross-over layer is used as an electrical isolation layer between different electrodes, to prevent the different electrodes from conducting in an unneeded block. Therefore, any suitable non-conductive material is used, for example, a silicon-containing material.

According to some embodiments of the present disclosure, after the foregoing steps are performed, a passivation layer (not shown in the figure) may be further preferably disposed through patterning. The passivation layer is formed by using a suitable epitaxial grown or deposition process, and is patterned with a specific mask and/or a photoresist. The passivation layer is made of an organic/inorganic dielectric material, preferably at least one of SiO₂, SiONₓ, or SiNₓ (where x is approximately in a range of 0.1 to 1).

In conclusion, in the manufacturing method for a high electron mobility transistor provided in the present disclosure, because differences in lattice matching features and many advantages of the protection layer, the barrier layer, and the cover layer are suitably used. In this way, in addition to that the protection layer can be removed by using a simple etching method to form the gate opening, an overall process is simplified because the p-type layer does not need to be patterned. Further, not only problems of a decrease in a yield and an increase in the conductive impedance can be avoided, but also a higher tolerance to the thickness of the barrier layer is provided, to ensure that a finished product has a sufficient threshold voltage. In addition, because the cover layer is disposed below the p-type layer, the n-type carrier in the cover layer may compensate for a negative impact caused when the p-type layer improves a threshold voltage on a conductive impedance. Therefore, compared with the conventional technology, the manufacturing method for a high electron mobility transistor provided in the present disclosure not only can effectively reduce costs and working hours, but also can reduce a process technology threshold, and can improve a product yield.

The present disclosure is described in detail. The foregoing descriptions are merely preferred embodiments of the present disclosure, but are not intended to limit the scope of the present disclosure. In other words, equal changes and modifications that can be made by any person of ordinary skill in the art without departing from the spirit and scope of the present disclosure shall fall within the protection scope of the present disclosure.

## Claims

1. A manufacturing method for a high electron mobility transistor, comprising the following steps:
(a) providing a semiconductor substrate (100), wherein the semiconductor substrate (100) comprises a channel layer (108) and a barrier layer (110) located above the channel layer (108);
(b) forming a protection layer (200A) at a position that is above the semiconductor substrate (100) and that corresponds to a gate opening (202);
(c) forming a cover layer (112) above the semiconductor substrate (100) and around the protection layer (200A), and removing the protection layer (200A) to form the gate opening (202); and
(d) forming a p-type layer (P) above the gate opening (202) and the cover layer (112), wherein
a material of the cover layer (112) is undoped, un-intentionally doped, or n-type-doped gallium nitride or aluminum gallium nitride.

2. The manufacturing method according to claim 1, further comprising the following steps:
(e) forming a first dielectric layer (200B) above the p-type layer (P) through patterning, to expose the p-type layer (P) at positions corresponding to a source opening (204) and a drain opening (206), and defining an active region (M);
(f) performing an etching process at the positions corresponding to the source opening (204) and the drain opening (206), to form the source opening (204) and the drain opening (206);
(g) forming an ohmic contact metal layer (210A) above the source opening (204) and the drain opening (206) through patterning, and alloying the ohmic contact metal layer (210A);
(h) forming a second dielectric layer (200C) through patterning, to cause the second dielectric layer (200C) to cover a part of the first dielectric layer (200B);
(i) forming a first metal layer (210B) through patterning, to cause the first metal layer (210B) to cover the positions corresponding to the source opening (204), the gate opening (202), and the drain opening (206), and cover a part of the first dielectric layer (200B) and a part of the second dielectric layer (200C); and
(j) forming a second metal layer (220) through patterning, to cause the second metal layer (220) to cover the positions corresponding to the source opening (204) and the drain opening (206), and cover a part of the first metal layer (210B).

3. The manufacturing method according to claim 1, wherein a length of the gate opening (202) is in a range of 1.0 micrometer to 3.0 micrometers.

4. The manufacturing method according to claim 1, wherein a material of the protection layer (200A) is silicon nitride.

5. The manufacturing method according to claim 1, wherein a thickness of the protection layer (200A) is in a range of 20 nanometers to 50 nanometers.

6. The manufacturing method according to claim 1, wherein the protection layer (200A) is formed by using a low pressure chemical vapor deposition (LPCVD) method.

7. The manufacturing method according to claim 1, wherein a thickness of the cover layer (112) is in a range of 50 nanometers to 150 nanometers.

8. The manufacturing method according to claim 1, wherein a material of the p-type layer (P) is p-type-doped gallium nitride.

9. The manufacturing method according to claim 1, wherein a thickness of the p-type layer (P) is in a range of 70 nanometers to 100 nanometers.

10. The manufacturing method according to claim 1, wherein before forming the protection layer (200A), the method further comprises the following step: forming an in situ dielectric layer above the barrier layer (110).

11. The manufacturing method according to claim 10, wherein a thickness of the in situ dielectric layer is in a range of 2.0 nanometers to 3.0 nanometers.

12. The manufacturing method according to claim 2, wherein a material of the first dielectric layer (200B) is silicon nitride.

13. The manufacturing method according to claim 2, wherein the first dielectric layer (200B) is formed by using a low pressure chemical vapor deposition method.

14. The manufacturing method according to claim 2, wherein the first dielectric layer (200B) covers a part of the p-type layer (P).

15. The manufacturing method according to claim 2, wherein the source opening (204) and the drain opening (206) are respectively a groove exposing the barrier layer (110) or a groove exposing the channel layer (108).

16. The manufacturing method according to claim 2, wherein a process temperature of alloying the ohmic contact metal layer (210A) is in a range of 500 °C to 550 °C.

17. The manufacturing method according to claim 2, wherein a material of the second dielectric layer (200C) is silicon nitride.

18. The manufacturing method according to claim 2, wherein the second dielectric layer (200C) is formed by using a plasma-enhanced chemical vapor deposition (PECVD) method.

19. The manufacturing method according to claim 2, wherein a thickness of the second dielectric layer (200C) is less than or equal to 500 nanometers.
